# EUROPEAN PATENT APPLICATION

(11) **EP 2 197 038 A1**
(43) Date of publication of application: **16.06.2010**
(21) Application number: 08834094.8
(22) Date of filing: 26.09.2008
(51) Int. Cl.: H01L 31/04

(54) **SUBSTRATE FOR SOLAR CELL AND SOLAR CELL**

(30) Priority: 28.09.2007 JP 2007255657; 30.03.2008 JP 2008088957
(71) Applicant: Fujifilm Corporation, Tokyo 106-8620 (JP)
(72) Inventor: YAGO, Haruo, Ashigarakami-gun Kanagawa 258-8577 (JP); AONO, Naruhiko, Ashigarakami-gun Kanagawa 258-8577 (JP); HOSOYA, Youichi, Ashigarakami-gun Kanagawa 258-8577 (JP); SATO, Tadanobu, Ashigarakami-gun Kanagawa 258-8577 (JP)
(74) Representative: HOFFMANN EITLE
(86) International application number: PCT/JP2008/067557
(87) International publication number: WO 2009/041658

(57) **Abstract**

A substrate for a solar cell, containing a metal substrate and an anodic oxidation film provided on the metal substrate, wherein on a surface of the anodic oxidation film, pores in a diameter of 10 nm to 600 nm are formed; and a solar cell using the same.

## Description

### TECHNICAL FIELD

The present invention relates to a substrate for a solar cell that is flexible, has good voltage resistance characteristics and provides good adhesion properties to an upper layer to form a thin-film solar cell; and also relates to a solar cell using the same.

### BACKGROUND ART

Glass substrates are mainly used as thin-film solar cell substrates. However, a glass substrate is fragile and must be treated with considerable care and its lack of flexibility limits the scope of the application. Recently, solar cells have attracted much attention as power supply sources to buildings including homes. It is inevitable to upsize solar cells in order to ensure sufficient electric power to supply, and there has been a demand for a more lightweight substrate that should contribute to production of solar cells with larger areas.
However, a glass substrate would be even more fragile if it is thinned for reduction in weight. Therefore, there has been a demand for development of a less fragile and more flexible substrate material that can be reduced in weight as compared to the glass substrate.

The glass substrate is relatively expensive as compared to a photoelectric conversion layer material for a solar cell, and an inexpensive substrate material is desired in the expectation that such an inexpensive material will help promote the use of solar cells. If a metal is used as such a substrate material, its insulation from a solar cell material arranged thereon is difficult, while a resin substrate cannot withstand a high temperature exceeding 400°C that is necessary to farm a solar cell.

Use of a metal substrate also causes a problem in which the thermal expansion coefficient of the metal substrate differs from that of the semiconductor layer of the photoelectric conversion layer, so that the semiconductor layer is susceptible to peeling. To deal with this problem, JP-A-2006-80370 ("JP-A" means unexamined published Japanese patent application) discloses that a glass layer containing 40 to 60 wt% of SiO₂, 15 to 30 wt% of B₂O₃, 2 to 10 wt% of Na₂O, and 8 to 20 wt% of TiO₂ is formed on the metal substrate. Further, JP-A-2006-25535 discloses that a first insulating layer is formed on a metal material by a sol-gel method and further forming a second insulating layer of another insulating material is further formed, to insulate remaining pinholes. However, there has been a problem in which sufficient voltage resistance cannot be obtained in these methods. JP-A-2000-349320 discloses that an anodic oxidation film with a thickness of 0.5 µm or more is formed as an insulating film. However, there is a problem in which when such an insulating layer is formed only on one side, the shape may be curved due to the difference in thermal expansion coefficient in this method during the process of manufacturing a solar cell.

### DISCLOSURE OF INVENTION

The present invention has been made in view of the above circumstances. According to the present invention, there can be provided a substrate for a solar cell being lighter than a glass substrate, highly thermally conductive, less fragile, capable of making a photoelectric conversion layer less susceptible to peeling, flexible, and highly insulating; and a solar cell using the same, that is good in voltage resistance characteristics.

According to the present invention, there is provided the following means:
(1) A substrate for a solar cell, comprising:
   a metal substrate; and
   an anodic oxidation film provided on the metal substrate,
   wherein on a surface of the anodic oxidation film, pores in a diameter of 10 nm to 600 nm are formed.
(2) The substrate for a solar cell as described in the above item (1), wherein a diameter of the pores formed on a surface of the anodic oxidation film is 25 nm to 600 nm.
(3) The substrate for a solar cell as described in the above item (1) or (2), wherein a diameter of the pores forked on a surface of the anodic oxidation film is 60 nm to 600 nm.
(4) The substrate for a solar cell as described in any one of the above items (1) to (3), wherein the metal substrate is a substrate containing a metal selected from the group consisting of aluminum, zirconium, titanium magnesium, niobium and tantalum.
(5) The substrate for a solar cell as described in any one of the above items (1) to (4), wherein the metal substrate is an aluminum substrate.
(6) The substrate for a solar cell as described in any one of the above items (1) to (5), wherein pores formed in the anodic oxidation film has a random structure.
(7) The substrate for a solar cell as described in any one of the above items (1) to (6), wherein the anodic oxidation film is formed on an end face and both sides of the metal substrate.

(8) A solar cell, comprising:
   the substrate for a solar cell as described in any one of the above items (1) to (7), and
   a photoelectric conversion layer provided on the substrate for a solar cell,
      wherein the photoelectric conversion layer comprises a semiconductor layer comprising Group Ib, IIIb and VIb elements.
(9) The solar cell as described in the above item (8), wherein the semiconductor layer comprises at least one element selected from the group consisting of copper (Cu), silver (Ag), indium (In), gallium (Ga), sulfur (S), selenium (Se), and tellurium (Te).
(10) A solar cell, comprising:
   the substrate for a solar cell as described in any one of the above items (1) to (7), and
   a photoelectric conversion layer provided on the substrate for a solar cell,
   wherein the photoelectric conversion layer comprises a semiconductor layer comprising a Group IVb element, a semiconductor layer comprising Group IIIb and Vb elements, a semiconductor layer comprising Group IIb and VIb elements, a layer comprising a Group Ib element, a layer comprising a Group IIb element, a layer comprising a Group IVb element, and/or a layer comprising a Group VIb element.

Other and further features and advantages of the invention will appear more fully from the following description, taking the accompanying drawing into consideration.

### BRIEF DESCRIPTION OF DRAWING

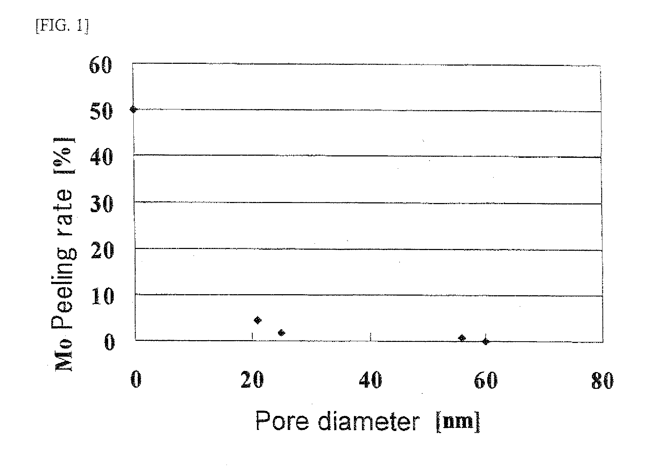

[FIG. 1. Fig. 1 shows the result of evaluation of the peeling rate in Example 1.

### BEST MODE FOR CARRYING OUT INVENTION

The substrate for a solar cell of the present invention includes a metal substrate and an anodic oxidation film provided on the metal substrate, wherein pores in a diameter of 10 nm to 600 nm are formed on the surface of the anodic oxidation films.
In view of good adhesion properties, the diameter of the pores on the surface is preferably from 25 nm to 600 nm, more preferably from 60 nm to 600 nm.
According to the present invention, an insulating oxide film is formed on the surface of the metal substrate by anodic oxidation, so that a flexible substrate having insulating properties is obtained, with which an inexpensive solar cell can be produced. In addition, the substrate for a solar cell of the present invention has good adhesion properties and can make a photoelectric conversion layer less susceptible to peeling.

The metal substrate to be used may be made of a material from which a metal oxide film can be formed as an insulator on the surface by anodic oxidation. The thermal expansion coefficients of metal oxide films are generally smaller than those of metals and close to those of semiconductors. Therefore, the oxide film formed on the surface of the metal substrate preferably has a thermal expansion coefficient almost equal to that of the material used to form the photoelectric conversion layer. Examples of such a material include aluminum (Al), zirconium (Zr), titanium (Ti), magnesium (Mg), niobium (Nb), tantalum (Ta), and an alloy thereof. In view of cost and the characteristics required for solar cells, aluminum is most preferred.

A Group I-III-VI semiconductor composed of copper (Cu), silver (Ag), gallium (Ga), indium (In), sulfur (S), selenium (Se), tellurium (Te) or the like may be used to form a copper-indium-gallium-selenium-series (CIGS-series) solar cell. Concerning this case, the thermal expansion coefficient of Mo of the back side electrode layer (5 × 10⁻⁶/K) is smaller than that of soda-lime glass or that of CIGS (9 × 10⁻⁶/K). A stainless steel substrate has a thermal expansion coefficient of 10 × 10⁻⁶/K. In contrast, in the anodized aluminum substrate, the anodic oxidation (alumina) film has a thermal expansion coefficient of 7.5 × 10⁻⁶/K, which is closer to that of Mo than to that of the stainless steel. Therefore, thermal distortion will be reduced during the film forming process when the anodized aluminum substrate is used than when a stainless steel substrate is used. Therefore, curving, curling, or peeling of a film can be prevented.

Aluminum has a thermal expansion coefficient of 22 × 10⁻⁶/K. There is a difference in thermal expansion between aluminum and the anodic oxidation film made of alumina. Therefore, anodic oxidation films having substantially the same thickness are more preferably formed on both sides of the aluminum substrate. The difference between the thickness of the anodic oxidation film formed on one side and the thickness of the anodic oxidation film formed on the other side can be reduced, so that both sides can be equal in distortion by heating and that curving, curling and peeling of a film can be prevented. Considering that the photoelectric conversion layer is formed on one surface of the substrate, it is more preferred that the anodic oxidation film (alumina) on the other surface on which no photoelectric conversion layer is formed is made thicker for a balance between the thermal distortions. Considering that the thickness of the photoelectric conversion layer is generally about 3 µm, it is preferable to make the thickness of the film on the rear surface side larger than that of the insulating film on the photoelectric-conversion-layer-formed side. The difference between the thickness of the anodic oxidation film formed on one side, and the total thickness of the anodic oxidation film formed on the other side and the photoelectric conversion layer is preferably from 0.001 to 5 µm, further preferably from 0.01 to 3 µm, and more preferably from 0.1 to 1 µm.

The anodic oxidation method on both surfaces may be, for example, a method of coating an insulating material on one surface, and subjecting the both surfaces to anodic oxidation one by one; and a method of subjecting both surfaces to anodic oxidation simultaneously.

The process of forming an oxide film on the metal substrate preferably includes forming the oxide film also on the end faces so that the metal part can be entirely covered with the oxide film. In this case, the metal can be prevented from reacting with chemical substances used as raw materials for forming a photoelectric conversion layer on the substrate, or the photoelectric conversion part-forming layer can be prevented from being contaminated with the material of the substrate, so that the photoelectric conversion efficiency of the solar cell can be prevented from being degraded or quickly reduced (particularly in vapor deposition of CIGS, selenium or sulfur is prevented from reacting with aluminum).

In addition, when the surface of the metal substrate (e.g., an aluminum substrate) is roughened, asperities are also formed on the surface of the aluminum oxide layer, which can improve adhesion properties between the alumina and a conductive layer (metal or semiconductor) formed thereon and particularly prevent film peeling of a metal layer having a different (larger) thermal expansion coefficient. Such a texture may be realized by subjecting the metal surface to mechanical polishing, chemical polishing, electric polishing, or combination thereof, before the anodic oxidation.

Asperities may also be formed by controlling the pore size and the density of pores formed on the anodic oxidation film. The asperities may be formed by a method including subjecting the metal surface to mechanical polishing, chemical polishing, electric polishing, or combination thereof before anodic oxidation, and then subjecting the surface to anodic oxidation. In the present invention, the pores specifically have a diameter (pore size) of 10 nm to 600 nm. In this case, when metal such as Mo is vapor-deposited to form a back side electrode on the anodized aluminum surface having the recessed structures, the metal portion intrudes into the structures to have an increased contact area, so that the adhesion strength increases. If the pores are too small, vapor-deposited metal will not enter the pores and will form a structure with which the pores are capped, so that the contact area cannot be increased, which will make the adhering effect small. Therefore, the vapor-deposited Mo surface has small asperities, which less contributes to the adhesion properties between Mo and a CIGS layer. In contrast, if the pore size is too large, the surface area at the interface between Mo and the alumina layer or between Mo and the CIGS layer will increase to increase the adhesion strength, but, for example, a photoelectric conversion layer mainly composed of CIGS will be affected by the asperities of the Mo surface, so that events leading to a reduction in electric generation efficiency may occur, such as increase of the defects, degradation of the crystallinity of CIGS and irregularities in crystal orientation.

When a Na compound is embedded in the pores, Na can be supplied to the light absorption layer even from a metal substrate not including blue plate glass, so that the electric generation efficiency of a CIGS-type solar cell can be improved.

The aluminum substrate is provided with an anodic oxidation film as described above. A photoelectric conversion layer containing a chalcopyrite-series copper-indium-selenium-series compound (CIS) or copper-indium-gallium-selenium-series compound (CIGS) comprising a semiconductor composed of Group Ib, IIIb and VIb elements such as Cu, Ag, In, Ga, S, Se, and Te (Group I-III-VI semiconductor); a semiconductor composed of Group IIb and VIb elements such as CdTe (Group II-VI semiconductor); a semiconductor composed of a Group IVb element such as Si (Group IV semiconductor); or a semiconductor composed of Group IIIb and Vb elements such as GaAs (Group III-V semiconductor) may be formed on such a substrate so that a solar cell can be obtained. In the present description, the short periodic table is used to describe group elements.

The anodic oxidation process may include placing the aluminum substrate in an electrolytic bath containing an electrolyte and applying a voltage between the aluminum substrate and the electrode to energize the substrate so that anodic oxidation is performed. When the electrode is placed to one side of the aluminum substrate, the anodic oxidation film is grown only on one side. Therefore, the anodic oxidation may be performed on each side (twice in total), so that both sides can be anodized. For example, the apparatus described in JP-A-2001-140100 or JP-A-2000-17499 may be used. When electrodes are placed to both sides of the aluminum substrate, both sides can be simultaneously anodized. In this case, the voltage applied to both sides may be controlled, or the current flow may be controlled by controlling the distance between each electrode and the aluminum substrate. In this case, alternatively, the concentration, temperature and/or components of the electrolyte on each of the front and back sides of the aluminum substrate may be controlled so that the thickness and quality of the anodic oxidation layer can be controlled on both sides.

Conventionally known anodizing methods may be used to form an anodized surface with low roughness or to control micropores. Such methods are preferably performed under the same conditions as those of the self-ordering method. The electrolysis voltage is preferably in the range of 10 V to 240 V.

Also preferably used is a method including repeating intermittent on-off control of current, while keeping DC voltage constant, or a method including repeating on-off control of current, while intermittently changing DC voltage. These methods are advantageous in that fine micropores are formed on the anodic oxidation film, so that uniformity is improved particularly in the process of sealing by electrodeposition. When the order should be reduced, these conditions do not have to be used, and the voltage, the current, the concentration of the solution, the temperature of the solution, or the type of the solution may be actively changed in the process of anodic oxidation.

When the anodizing treatment is performed at low temperature, micropores can be regularly arranged and uniform in pore size.
In the present invention, the anodizing treatment may be performed at relatively high temperature, so that the arrangement of micropores can be disturbed and that varieties in pore size can be easily kept in a specific range. Varieties in pore size may also be controlled by the treatment time.

In an exemplary method of producing the solar cell of the present invention, the aluminum plate having undergone the mirror finishing process described above may be subjected to the anodizing treatment under the conditions shown below.
(1) The anodizing treatment is performed using an aqueous sulfuric acid electrolyte with a concentration of 0.1 mol/L to 0.2 mol/L at a temperature of 5°C to 35°C and a voltage of 10V to 30V for a treatment time of 1 to 30 minutes, so that micropores with an average pore size of 10 to 30 nm and an average pore interval of 40 to 70 nm are formed.
(2) The anodizing treatment is performed using an aqueous oxalic acid electrolyte with a concentration of 0.4 mol/L to 0.6 mol/L at a temperature of 5°C to 35°C and a voltage of 30 V to 120 V for a treatment time of 5 minutes to 2 hours, so that micropores with an average pore size of 40 to 70 nm and an average pore interval of 120 to 180 nm are formed.
(3) The anodizing treatment is performed using an aqueous succinic acid electrolyte with a concentration of 0.01 mol/L to 2 mol/L at a temperature of 5°C to 35°C and a voltage of 120 V to 240 V for a treatment time of 0.5 to 12 hours, so that micropores with an average pore size of 100 to 150 nm and an average pore interval of 300 to 600 nm are formed.
   When a mixed acid is prepared, the pore interval can be freely changed in the range of 10 to 150 nm.
   The pore may be enlarged to have any size of up to the pore interval by immersion in phosphoric acid.

### <Evaluation of Micropores>

The average more size and the average pore interval of the pores may be determined by performing image analysis of an SEM surface photograph.

### Methods for Measuring Average Pore Size and Average Pore Interval

An SEM photograph (inclination angle: 0°) is taken with an FE-SEM (Field Emission Type Scanning Electron Microscope) at a magnification of 1 to 150,000 adjusted depending on the pore size. Using the photograph, the distance between the centers of adjacent pores is measured at 30 points, and the average of the 30 measurements is calculated as the average pore interval.
The average pore size may be determined by a process including tracing the contours of about 100 pores on a transparent OHP sheet and then approximating the pore sizes by the diameters of equivalent circles using commercially available image analysis software (trade name: Image Factory, manufactured by Asahi-Hi-Tech Co., Ltd.). The resulting value is defined as the average pore size. Any other image analysis software having a similar function may be alternatively used. However, the shapes traced on a transparent sheet such as an OHP sheet should preferably subjected to image analysis, because arbitrariness associated with the setting of the threshold in the binarization has to be eliminated as much as possible.

The substrate for a solar cell of the present invention containing a metal substrate and an insulating layer provided on the substrate is flexible and excellent in insulating properties and provides good adhesion properties between the insulating layer and a layer formed on the insulating layer. The solar cell of the present invention using this substrate is lightweight, flexible, producible at low cost, and less susceptible to peeling of the photoelectric conversion layer or the back side electrode, and has favorable voltage resistance characteristics.

The solar cell of the present invention is produced with an inexpensive lightweight anodized aluminum substrate and therefore has a reduced weight and high thermal conductivity and is flexible and less fragile. When the substrate provided with the anodic oxidation film on both sides is used, thermal distortions are cancelled between both sides, so that the deformation of the substrate such as curling and curving can be prevented. Further, the textured structure formed on the substrate surface improves the adhesion between the substrate and the metal electrode, so that film peeling can be prevented. Further, the anodic oxidation layer may be provided on both sides and the end face of the metal substrate, and pores may be filled with another insulating material, so that not only insulation can be ensured, but also a chemical reaction of the metal substrate can be prevented in the process of forming the films for the solar cell.
When the surface roughness is small, the adhesion is generally low. However, the pores formed by anodic oxidation increase the contact area with the metal layer formed thereon and improve the adhesion properties. If the surface roughness is large, the crystallinity of the photoelectric conversion layer may be degraded so that the conversion efficiency may be reduced. According to the present invention, however, the increase in the surface roughness can be kept at a relatively low level, and therefore, the crystallinity of the photoelectric conversion layer can be improved, while the conversion efficiency is not reduced. Thus, film forming with good crystallinity and strong adhesion are both achieved. In addition, when the pores have a random structure, a periodic structure is less likely to form, so that optical wavelength dependence is less likely to occur.

### EXAMPLES

The present invention will be described in more detail based on the following examples, but the invention is not intended to be limited thereby.
In the following examples, an aluminum material FS003 manufactured by SUMITOMO LIGHT METAL INDUSTRIES, LTD. with a 3 cm square area was used.

### Example 1

A piece of the 3 cm square aluminum substrate was is subjected to anodic oxidation with sulfuric acid (170 g/l in concentration) at a temperature of 35°C and a DC voltage of 13 V, so that an anodized alumina substrate with an average pore size of 21 nm and an average distance of 45 nm between the centers of adjacent pores was obtained. Another piece of the substrate was treated for a different immersion time so that a pore size of 25 nm was obtained.
A piece of the substrate was also is subjected to anodic oxidation with oxalic acid (0.5 M in concentration) at a temperature of 16°C and a DC voltage of 40 V, so that an anodized alumina substrate with an average pore size of 56 nm and an average distance of 150 nm between the centers of adjacent pores was obtained. Another piece of the substrate was also treated for a different time so that a pore size of 60 nm was obtained.
The anodized alumina films all had a thickness of 3 µm or more, and both sides of the aluminum substrate were evenly subjected to anodic oxidation.
Thereafter, a Mo film was formed by sputtering at a substrate temperature of 120°C, and then heated to 520°C and cooled to room temperature, In this process, utilizing the phenomenon that the Mo film, which is weakly adhered, is peeled by the stress applied due to the difference between the thermal expansion coefficients of aluminum, alumina and Mo, the peeling rate was evaluated using this process. The results are shown in Fig. 1.
As shown in Fig. 1, it shows that when pores are formed, the peeling rate becomes low. When the pore size is 25 nm or more, the peeling rate is reduced to 2% or less. This is considered to be because the Mo film is partially formed inside the pores and on the wall surface of the pores, so that the contact area between the alumina and the Mo layer is increased and that the adhesion properties are improved.
When the pore size was increased to 60 nm or more, the peeling rate was reduced to zero, and stronger adhesion properties were obtained.

### Example 2

An anodic oxidation film with 10 µm in thickness was formed on one side of the substrate under the same conditions as those in Example 1, and then a Mo thin film with 0.4 µm in thickness was formed by sputtering, so that a support sample was obtained. As a result, cracking and peeling occurred on the anodic oxidation layer.

### Example 3

An anodized aluminum substrate was used in which anodic oxidation films were formed on both sides of the substrate under the same conditions as those for the pores of a size of 60 nm produced with oxalic acid in Example 1. After a Mo layer was formed on the anodized aluminum substrate by RF sputtering (high frequency sputtering), a NaF layer was formed thereon by RF sputtering, and a Mo layer was further formed thereon by RF sputtering. The resulting Mo/NaF/Mo multilayer film had a thickness of about 1.0 µm. A CuInGaSe₂ thin film was deposited on the Mo film in a vacuum chamber. In the deposition of the CuInGaSe₂ thin film, a Cu (the primary component of CuInGaSe₂) evaporation source, an In evaporation source, a Ga evaporation source, and a Se evaporation source were provided in the vacuum chamber 1, and the Cu, In, Ga, Se evaporation source crucibles were heated at the degree of vacuum of about 10⁻⁷ Torr so that each element was evaporated. In this process, the crucible temperature was controlled as needed. The CuInGaSe₂ thin film was formed to have a two-layer structure as described below. The first layer of the two-layer structure was so formed that Cu was in excess of the total of In and Ga in the atomic composition, and the second layer of the two-layer structure was subsequently so formed that the total of In and Ga was in excess of Cu in the atomic composition. The substrate temperature was kept constant at 550°C. The first layer was vapor-deposited with a thickness of about 2 µm. At this time, the atomic composition ratio Cu/(In+Ga) was about from 1.0 to 1.2. The second layer was then vapor-deposited with a thickness of about 1 µm so that the final atomic composition ratio Cu/(In+Ga) could be 0.8 to 0.9.

Plural semiconductor layers were then formed as window layers. First, an about 50 nm thick CdS film was deposited by a chemical deposition method. The chemical deposition method was performed by heating at about 80°C an aqueous solution containing Cd nitrate, thiourea and ammonia and immersing the light absorption layer in the aqueous solution. An about 80 nm thick ZnO film was further formed on the CdS film by a MOCVD method.
Next, an Al-added ZnO film as a transparent conductive film was deposited into a thickness of about 200 nm thereon by a MOCVD method.
Finally, Al was vapor-deposited to form an extraction electrode, so that a solar cell was obtained.

The characteristics of the resulting solar cell were evaluated using simulated sunlight under the conditions of an Air Mass (AM) of 1.5 and 100 mW/cm². As a result, a conversion efficiency of 10.0% was obtained. The result indicates that even when the anodized aluminum substrate according to the present invention is used to form a solar cell, the resulting solar cell shows sufficient photoelectric conversion efficiency.

### Example 4

An anodized aluminum substrate was used in which anodic oxidation films were formed on both sides of the substrate under the same conditions as those in Example 3. After a Mo layer was formed on the anodized aluminum substrate by RF sputtering (high frequency sputtering), a NaF layer was formed thereon by RF sputtering, and a Mo layer was further formed thereon by RF sputtering. The resulting Mo/NaF/Mo multilayer film had a thickness of about 1.0 µm.
A CuInGaSe₂ thin film was deposited on the Mo film in a vacuum chamber. Initially, while the vapor deposition rate from each of evaporation sources of In, Ga and Se was controlled to set the atomic composition ratio of Ga/(In + Ga) to about 0.30, a thin film composed of In, Ga and Se was deposited at a substrate temperature of 400°C. Next, a film composed of Cu and Se was deposited thereon at a substrate temperature of 550°C while the vapor deposition rate from each of evaporation sources of Cu and Se was controlled. Finally, a thin film composed of In, Ga and Se was deposited thereon at a substrate temperature of 550°C while the vapor deposition rate from each of evaporation sources of In, Ga and Se was controlled. The thickness of the thus-obtained CuInGaSe₂ film was about 2.0 µm.

Plural semiconductor layers were then formed as window layers. First, an about 50 nm thick CdS film was deposited by a chemical deposition method. The chemical deposition method was performed by heating at about 80°C an aqueous solution containing Cd nitrate, thiourea and ammonia and immersing the light absorption layer in the aqueous solution. An about 80 nm thick ZnO film was further formed on the CdS film by a MOCVD method.
Next, an Al-added ZnO film as a transparent conductive film was deposited into a thickness of about 200 nm thereon by a MOCVD method.
Finally, Al was vapor-deposited to form an extraction electrode, so that a solar cell was obtained.

The characteristics of the resulting solar cell were evaluated using simulated sunlight under the conditions of an Air Mass (AM) of 1.5 and 100 mW/cm². As a result, a conversion efficiency of 10.2% was obtained. The result indicates that even when the anodized aluminum substrate according to the present invention is used to form a solar cell, the resulting solar cell shows sufficient photoelectric conversion efficiency.

### Example 5

An anodized aluminum substrate was used in which anodic oxidation films were formed on both sides of the substrate under the same conditions as those in Example 3. After a Mo layer was formed on the anodized aluminum substrate by RF sputtering (high frequency sputtering), a NaF layer was formed thereon by RF sputtering, and a Mo layer was further formed thereon by RF sputtering. The resulting Mo/NaF/Mo multilayer film had a thickness of about 1.0 µm.
A Cu-Ga alloy and metal In were used as targets to form a laminate film composed of a Cu-Ga film and an In film on the above-described Mo by sputtering. The Ga content by percentage in the Cu-Ga alloy was 30% by atom. The sputtering was conducted in an Ar gas atmosphere.
Next, this substrate, in which the Cu-Ga film and the In film were laminated, was put into an electric furnace, and then heated to about 520°C in an atmosphere containing 1% by volume of H₂Se gas. By this treatment, a CuInGaSe₂ thin film was formed. The thickness of the resultant CuInGaSe₂ film was about 2.0 µm.

Plural semiconductor layers were then formed as window layers. First, an about 50 nm thick CdS film was deposited by a chemical deposition method. The chemical deposition method was performed by heating at about 80°C an aqueous solution containing Cd nitrate, thiourea and ammonia and immersing the light absorption layer in the aqueous solution. An about 80 nm thick ZnO film was further formed on the CdS film by a MOCVD method.
Next, an Al-added ZnO film as a transparent conductive film was deposited into a thickness of about 200 nm thereon by a MOCVD method.
Finally, Al was vapor-deposited to form an extraction electrode, so that a solar cell was obtained.

The characteristics of the resulting solar cell were evaluated using simulated sunlight under the conditions of an Air Mass (AM) of 1.5 and 100 mW/cm². As a result, a conversion efficiency of 9.7% was obtained. The result indicates that even when the anodized aluminum substrate according to the present invention is used to form a solar cell, the resulting solar cell shows sufficient photoelectric conversion efficiency.

### INDUSTRIAL APPLICABILITY

The substrate for a solar cell of the present invention has good insulating properties and provides good adhesion properties between the insulating layer and a layer formed thereon. Therefore, the substrate for a solar cell of the present invention is suitable for use in solar cells.

Having described our invention as related to the present embodiments, it is our intention that the invention not be limited by any of the details of the description, unless otherwise specified, but rather be construed broadly within its spirit and scope as set out in the accompanying claims.

This non-provisional application claims priority under 35 U.S.C. § 119 (a) on Patent Application No. 2007-255657 filed in Japan on September 28,2007, and Patent Application No. 2008-88957 filed in Japan on March 30, 2008, each of which is entirely herein incorporated by reference.

## Claims

1. A substrate for a solar cell, comprising:
a metal substrate; and
an anodic oxidation film provided on the metal substrate,
wherein on a surface of the anodic oxidation film, pores in a diameter of 10 nm to 600 nm are formed.

2. The substrate for a solar cell according to Claim 1, wherein a diameter of the pores formed on a surface of the anodic oxidation film is 25 nm to 600 nm.

3. The substrate for a solar cell according to Claim 1 or 2, wherein a diameter of the pores formed on a surface of the anodic oxidation film is 60 nm to 600 nm.

4. The substrate for a solar cell according to any one of Claims 1 to 3, wherein the metal substrate is a substrate containing a metal selected from the group consisting of aluminum, zirconium, titanium magnesium, niobium and tantalum.

5. The substrate for a solar cell according to any one of Claims 1 to 4, wherein the metal substrate is an aluminum substrate.

6. The substrate for a solar cell according to any one of Claims 1 to 5, wherein pores formed in the anodic oxidation film has a random structure.

7. The substrate for a solar cell according to any one of Claims 1 to 6, wherein the anodic oxidation film is formed on an end face and both sides of the metal substrate.

8. A solar cell, comprising:
the substrate for a solar cell according to any one of Claims 1 to 7, and
a photoelectric conversion layer provided on the substrate for a solar cell,
wherein the photoelectric conversion layer comprises a semiconductor layer comprising Group Ib, IIIb and VIb elements.

9. The solar cell according to Claim 8, wherein the semiconductor layer comprises at least one element selected from the group consisting of copper (Cu), silver (Ag), indium (In), gallium (Ga), sulfur (S), selenium (Se), and tellurium (Te).

10. A solar cell, comprising:
the substrate for a solar cell according to any one of Claims 1 to 7, and
a photoelectric conversion layer provided on the substrate for a solar cell,
wherein the photoelectric conversion layer comprises a semiconductor layer comprising a Group IVb element, a semiconductor layer comprising Group IIIb and Vb elements, a semiconductor layer comprising Group IIb and VIb elements, a layer comprising a Group Ib element, a layer comprising a Group IIb element, a layer comprising a Group IVb element, and/or a layer comprising a Group VIb element.
